# EUROPÄISCHE PATENTSCHRIFT

(11) **EP 0 387 798 B1**
(45) Veröffentlichungstag und Bekanntmachung des Hinweises auf die Patenterteilung: **29.09.1993**
(21) Anmeldenummer: 90104734.0
(22) Anmeldetag: 13.03.1990
(51) Int. Cl.: H02H 9/04, H01L 27/02, H03K 17/08

(54) **Monolithisch integrierbare Transistorschaltung zum Begrenzen von negativen Überspannungen**
Monolithic integrable transistor circuit for limitating a negative overvoltage
Circuit intégré monolithique à transistor pour limiter une surtension négative

(30) Priorität: 16.03.1989 EP 89104712
(43) Veröffentlichungstag der Anmeldung: 19.09.1990
(73) Patentinhaber: SIEMENS AKTIENGESELLSCHAFT, 80333 München (DE)
(72) Erfinder: Dietze, Andreas, Dipl.-Ing., D-8155 Valley/Grub (DE); Kriedt, Hans, D-8000 München 80 (DE)

(56) Entgegenhaltungen:
- DE-A- 2 654 419
- DE-A- 3 301 800
- US-A- 4 302 792
- PATENT ABSTRACTS OF JAPAN, Band 11, Nr. 77 (E-487)(2524), 7. März 1987; & JP-A- 61 232 657 (FUJITSU LTD.) 16.10.1986
- PATENT ABSTRACTS OF JAPAN, Band 7, Nr. 272 (E-214)(1417), 3. Dezemb er 1983; & JP-A- 58 153 361 (NIPPON DENKI K.K.) 12.09.1983
- IBM TECHNICAL DISCLOSURE BULLETIN, Band 29, Nr. 10, März 1987, Seit en 4677, 4678, Armonk, New York, US; "Electrostatic discharge protect device for integrated bipolar technology"

## Beschreibung

Die Erfindung betrifft eine monolithisch integrierbare Transistorschaltung nach dem Oberbegriff des Patentanspruchs 1 sowie Halbleiterstrukturen zur einfachen Realisierung solcher Transistorschaltungen.

Aus der DE-OS 26 54 419 sind Schaltungsanordnungen zur Spannungsbegrenzung auf elektrischen Leitern bekannt, bei denen eine steuerbare Strecke einer Halbleiteranordnung, insbesondere die Kollektor-Emitter-Strecke eines Transistors zwischen dem zu schützenden Leiter und dem Bezugspotential angeordnet ist. Vom Steuereingang der Halbleiteranordnung sind Dioden-Ketten jeweils in Sperrichtung zum zu schützenden Leiter bzw. zum Bezugspotential geschaltet. Zum Schutz vor positiven Hochspannungen auf dem zu schützenden Leiter ist die entsprechenden Dioden-Kette in Durchlaßrichtung vom zu schützenden Leiter zum Steuereingang der Halbleiteranordnung geschaltet, wobei die Anzahl der Dioden die maximal zulässige Spannung bestimmt. Bei integrierten Schaltungen sind solche Dioden-Ketten jedoch aufgrund ihres großen Flächenbedarfes möglichst zu vermeiden. Außerdem läßt sich der Spannungswert, bei dem die Spannungsbegrenzung eintreten soll, nur ungenau vorgeben und die Impedanz, mit dem eine solche Schaltung den zu schützenden Leiter belastet, ist relativ großen Streuungen unterworfen und begrenzt die verarbeitbare Signalfrequenz beträchtlich.

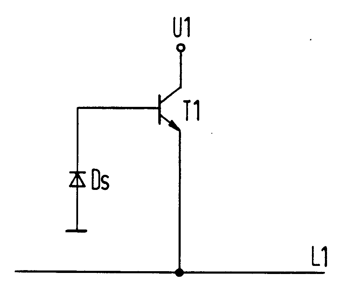

Aus der DE-OS 31 25 198, insbesondere Figur 3, ist eine Transistorschutzschaltung zum Schutz von elektrischen Leitern vor vorübergehenden positiven Hochspannungen bekannt, wobei der Emitter eines PNP-Transistors an den zu schützenden Leiter angeschlossen ist, der Kollektor dieses PNP-Transistors an das Bezugspotential geschaltet ist, der Basisanschluß dieses pnp-Transistors über eine Diode in Durchlaßrichtung an das Bezugspotential geschaltet ist und mit einer Bezugsvorspannung beaufschlagt ist. FIG 2 der DE-OS 31 25 198 zeigt die gleiche Schaltung mit einem NPN-Transistor, der gegen das positive Versorgungspotential geschaltet ist und somit gegen vorübergehende negative Hochspannungen schützt. Wenn der zu schützende Leiter beispielsweise an einen Bus oder einen Port eines Datensystems oder an einen Antennenausgang angeschlossen ist, so kann es vorkommen, daß auf dem Leiter Signalspannungen und auch ESD-Impulse auftreten, obwohl eine zu schützende und die Transistor-Schutzschaltung enthaltende Halbleiterschaltung außer Betrieb ist. In diesem Fall ist jedoch eine solche, aus der DE-OS 31 25 198 bekannte Transistor-Schutzschaltung ebenfalls außer Betrieb, da keine Bezugsvorspannung vorhanden ist.

Zum Schutz elektrischer Leiter vor vorübergehenden negativen Hochspannungen hat sich der Einsatz von Substratdioden bewährt. Substratdioden, die sowohl den entsprechenden Strom abführen können als auch einen geringen Wirkwiderstand aufweisen, belasten einen zu schützenden Leiter mit einer Kapazität, die üblicherweise größer als 1pF ist. Bessere Hochfrequenzeigenschaften weist eine aus der DE-OS 33 01 800 bekannte Schutzschaltung zum Schutz vor negativen Hochspannungen auf. Eine solche Schutzschaltung besteht aus zwei zueinander komplementären Transistoren, deren Basiselektroden miteinander verbunden sind wobei der Emitter des NPN-Transistors mit dem Signaleingang der zu schützenden Schaltung verbunden ist und sein Kollektor an die Klemme für das positive Versorgungspotential geschaltet ist, wobei der Emitter und der Kollektor des PNP-Transistors zusammengeschaltet sind und auf einem festen Potential liegen. Eine solche Schaltung belastet den zu schützenden Leiter mit einer zusätzlichen Kapazität von ca. 1 pF. Wenn auf dem zu schützenden Leiter jedoch höchstfrequente Signale übertragen werden sollten, so ist eine zusätzliche kapazitive Belastung von 1 pF in vielen Fällen nicht tragbar.

Aufgabe der Erfindung ist das Bereitstellen einer monolithisch integrierten Transistorschaltung zum Begrenzen vorübergehender negativer Hochspannungen auf einem elektrischen Leiter, die diesen zu schützenden Leiter nur sehr gering kapazitiv belastet, sodaß die Übertragung von höchstfrequenten Signalen auf diesem Leiter möglich ist.

Diese Aufgabe wird erfindungsgemäß durch eine Transistorschaltung nach dem Patentanspruch gelöst.

Aufbau und Funktionsweise einer erfindungsgemäßen monolithisch integrierbaren Transistorschaltung wird nachstehend anhand des in der Figur gezeigten Ausführungsbeispieles näher erläutert.

Die Figur zeigt als Schaltbild einer erfindungsgemäßen Transistorschaltung einen zu schützenden Leiter L1, der mit dem Emitter eines NPN-Transistors T1 verbunden ist. Der Kollektor des NPN-Transistors T1 ist an das positive Versorgungspotential U1 angeschlossen, der Basisanschluß des NPN-Transistors T1 ist mit dem Kathodenanschluß einer Substratdiode Ds verbunden und der Anodenanschluß dieser Substratdiode Ds ist an das Bezugspotential Masse angeschlossen. Hierbei ist darauf zu achten, daß die Substratdiode mit Hilfe einer möglichst kleinen Epitaxiewanne realisiert ist.

Eine solche Substratdiode besteht üblicherweise aus einer n-dotierten Epitaxiewanne auf p-dotiertem Substrat, die von einem Isolationsrahmen umgeben ist, wobei ein hochdotierter Bereich vom gleichen Leitungstyp wie die Wanne zum Herstellen eines Kontaktes zwischen einem Leiter und der Wanne vorgesehen ist. Dieser hochdotierte Bereich kann von relativ geringer Eindringtiefe sein, er kann aber auch bis in das Substrat hineinreichen.

Durch Verwendung einer Substratdiode mit entsprechend kleinen Abmessungen erhält man eine erfindungsgemäße Transistorschutzschaltung, die in einer durchschnittlichen Bipolartechnologie realisiert den zu schützenden Leiter mit einer zusätzlichen Kapazität belastet, die kleiner ist als 0,1 pF.

Bei erfindungsgemäßen Schaltungen wird der Leiter L1 zusätzlich mit einer Kapazität belastet, die sich aus der Serienschaltung aus der Sperrschichtkapazität der Basis-Emitterdiode des NPN-Transistors T1 und der Sperrschichtkapazität der Substratdiode Ds zusammensetzt. Die Kapazität der Substratdiode Ds bestimmt also entscheidend die zusätzliche kapazitive Belastung des elektrischen Leiters L1. Wird anstelle der Substratdiode Ds, wie aus der DE-OS 33 01 800 ein Transistor vorgesehen, so ist dessen Kapazität aufgrund der erheblich größeren Fläche der Epitaxiewanne erheblich größer.

Die Epitaxiewanne einer Substratdiode Ds in erfindungsgemäßen Schaltungen muß lediglich den Basisstrom des NPN-Transistors T1 führen, so daß der Wirkwiderstand dieser Substratdiode nicht kritisch ist.

## Patentansprüche

1. Monolithisch integrierbare Transistorschaltung zum Begrenzen vorübergehender negativer Hochspannungen auf einem elektrischen Leiter (L1), wobei der Emitteranschluß eines NPN-Transistors (T1) mit dem elektrischen Leiter (L1) verbunden ist, wobei der Kollektoranschluß dieses NPN-Transistors (T1) an ein Versorgungspotential (U1) geschaltet ist und wobei dieser NPN-Transistor (T1) nur bei Überschreiten eines vorgegebenen, gegenüber dem Bezugspotential (Masse) negativen Potentialschwellwertes leitend ist, **dadurch gekennzeichnet,** daß der Basisanschluß des NPN-Transistors (T1) mit dem Kathodenanschluß einer Diode (Ds) verbunden ist, daß der Anodenanschluß dieser Diode (Ds) an ein Bezugspotential (Masse) geschaltet ist und daß die Diode (Ds) durch eine Substratdiode realisiert ist.

## Claims

1. Monolithically integrable transistor circuit for limiting temporary negative high voltages on an electrical conductor (L1), the emitter terminal of an NPN transistor (T1) being connected to the electrical conductor (L1), the collector terminal of this NPN transistor (T1) being connected to a supply potential (U1), this NPN transistor (T1) being conductive only when a potential threshold value, which is negative with respect to the reference potential (earth) is exceeded, characterised in that the base terminal of the NPN transistor (T1) is connected to the cathode terminal of a diode (Ds), and that the anode terminal of this diode (Ds) is connected to a reference potential (earth), and in that the diode (Ds) is implemented by a substrate diode.

## Revendications

1. Circuit à transistors intégrable monolithiquement, pour limiter des hautes tensions négatives transitoires sur un conducteur électrique (L1), la borne d'émetteur d'un transistor NPN (T1) étant reliée au conducteur électrique (L1), la borne de collecteur de ce transistor NPN (T1) étant placée à un potentiel d'alimentation (U1), et ce transistor NPN (T1) n'étant passant que lors du dépassement d'une valeur seuil de potentiel prédéterminée, négative par rapport au potentiel de référence (Masse), caractérisé en ce que la borne de base du transistor NPN (T1) est reliée à la borne de cathode d'une diode (Ds), que la borne d'anode de cette diode (Ds) est placée à un potentiel de référence (Masse) et que la diode (Ds) est réalisée à l'aide d'une diode de substrat.
